# EUROPEAN PATENT SPECIFICATION

(11) **EP 3 333 506 B1**
(45) Date of publication and mention of the grant of the patent: **22.05.2024**
(21) Application number: 16840578.5
(22) Date of filing: 28.04.2016
(51) Int. Cl.: F25B 21/02, H01L 23/38, H01S 5/024, H01S 5/06, H10N 10/81

(54) **THERMOELECTRIC COOLING MODULE, OPTICAL DEVICE AND OPTICAL MODULE**
THERMOELEKTRISCHES KÜHLMODUL, OPTISCHE VORRICHTUNG UND OPTISCHES MODUL
MODULE DE REFROIDISSEMENT THERMOÉLECTRIQUE, DISPOSITIF OPTIQUE ET MODULE OPTIQUE

(30) Priority: 31.08.2015 CN 201510548768
(43) Date of publication of application: 13.06.2018
(73) Proprietor: Huawei Technologies Co., Ltd., Longgang District Shenzhen, Guangdong 518129 (CN)
(72) Inventor: FU, Xing, Shenzhen Guangdong 518129 (CN); YANG, Chengpeng, Shenzhen Guangdong 518129 (CN); ZHU, Ningjun, Shenzhen Guangdong 518129 (CN); LI, Quanming, Shenzhen Guangdong 518129 (CN)
(74) Representative: Körber, Martin Hans
(86) International application number: PCT/CN2016/080458
(87) International publication number: WO 2017/036149

(56) References cited:
- EP-B1- 1 965 446
- WO-A1-97/45882
- WO-A1-2006/019059
- WO-A1-2011/138522
- WO-A1-2017/165486
- CN-A- 1 190 492
- CN-A- 102 282 690
- CN-U- 202 792 678
- US-A1- 2002 121 094
- US-A1- 2004 155 251
- US-A1- 2005 257 821
- US-A1- 2007 221 264
- US-A1- 2009 288 425
- US-A1- 2010 031 986
- US-A1- 2011 048 486
- US-A1- 2012 060 889
- US-A1- 2015 241 636
- US-B1- 6 804 966

## Description

### TECHNICAL FIELD

The present invention relates to the field of communications technologies, and in particular, to a thermoelectric cooler, an optical sub-assembly, and an optical module.

### BACKGROUND

An optical sub-assembly is an important device in the optical communications field. A chip (in particular, a laser chip) in the optical sub-assembly has high sensitivity to a temperature. To ensure stability of the chip in the optical sub-assembly in sending or receiving signals, generally, a thermoelectric cooler (TEC) is used to perform accurate temperature control on the laser chip (for example, a temperature of the chip is controlled to be 45±0.1°C).

As the optical sub-assembly is developed toward a high speed (for example, developed from a 100G TOSA (transmitter optical sub-assembly) to a 400G TOSA), power consumption of the laser chip or other electronic parts and components located on a base plate of the TEC increases, and further, heat generated by the laser chip or other electronic parts and components increases, and performance thereof is affected. Therefore, for the heat, an effective heat dissipation solution needs to be provided.

US 6,804,966 B1 discloses a thermoelectric assembly, the thermoelectric assembly have a surface with a non-uniform thermal distribution between at least one first region and at least one second region, with the at least one first region having a higher heat flux than the at least one second region.

US 2012/060889 A1 discloses a thermoelectric module capable of minimizing thermally and physically induced stress that includes a pair of substrates having a plurality of electrically conductive contacts disposed on opposing faces.

US 2005/257821 A1 shows thermoelectric elements in a gradually decreasing density arrangement.

### SUMMARY

The present invention provides a thermoelectric cooler to effectively dissipate heat of a heat emitting element in an optical sub-assembly.

The present invention further provides an optical sub-assembly and an optical module.

According to the present invention, as defined by appended independent claim 1, a thermoelectric cooler is provided and configured to support a heat source device and perform temperature control on the heat source device, where the thermoelectric cooler includes a first base plate, a second base plate disposed opposite to the first base plate, and multiple couples of first elements, the first base plate is configured to support the heat source device, an accommodation space is formed between the first base plate and the second base plate, the multiple couples of first elements are arranged at intervals within the accommodation space, the multiple couples of first elements are all connected to the first base plate and the second base plate, the multiple couples of first elements are connected to an external power source to adjust a temperature difference between the first base plate and the second base plate by changing a voltage or a current and implement temperature control on the heat source device, the accommodation space includes a first area and a second area adjacent to the first area, the first area is disposed in a correspondence to the heat source device, and density of first elements in the first area is greater than density of first elements in the second area; the first area is connected to the second area, the multiple couples of first elements are arranged in the first area and the second area, and the multiple couples of first elements are arranged in such a manner that density gradually decreases in a direction from the first area to the second area. Each couple of first elements includes two element bodies, and the two element bodies are disposed at an interval and are both connected to the first base plate and the second base plate. The thermoelectric cooler further includes a conductor that is located on the second base plate and is close to the accommodation space, the conductor is electrically connected to one of two element bodies in outermost first elements within the accommodation space, and every two element bodies in the multiple couples of first elements are connected in series.

In a possible implementation, the second area includes a first subarea and a second subarea, the first subarea and the second subarea are respectively located on two sides of the first area, and the multiple couples of first elements are arranged in such a manner that density gradually decreases in a direction from the first area to the first subarea and in a direction from the first area to the second subarea.

In a possible implementation, the thermoelectric cooler further includes a temperature detector and a control circuit, the temperature detector is connected to the heat source device to detect a temperature of the heat source device and transfer the temperature to the control circuit, and the control circuit is configured to control voltage values or current values on the multiple couples of first elements.

In a possible implementation, the first base plate and the second base plate are made of an aluminum nitride material, an aluminum oxide material, or a silicon carbide material.

In a possible implementation, the thermoelectric cooler further includes a passive optical component disposed on the first base plate, and the passive optical component is located on one side opposite to the second area.

Further, according to an aspect, an optical sub-assembly is provided and includes a base, where the optical sub-assembly further includes the thermoelectric cooler according to any one of the foregoing possible implementations, the thermoelectric cooler is installed on the base, and the second base plate contacts a surface of the base.

According to a further aspect, an optical module is provided and includes a housing, where the optical module further includes the optical sub-assembly according to the above aspect, and the optical sub-assembly is disposed in the housing.

In the present invention, density of elements in an area corresponding to a heat source device is greater than density of elements in another area. Therefore, a thermoelectric cooler can dissipate heat of the heat source device on a first base plate in time, and this helps to effectively keep the heat source device on the first base plate at a constant temperature.

### BRIEF DESCRIPTION OF DRAWINGS

The invention is defined in the independent claim.

Additional features of the invention are provided in the dependent claims. In the following, parts of the description and drawings referring to embodiments which are not covered by the claims are not presented as embodiments of the invention, but as examples useful for understanding the invention.

To describe the technical solutions in the embodiments of the present invention more clearly, the following briefly describes the accompanying drawings required for describing the embodiments. Apparently, the accompanying drawings in the following description show merely some embodiments of the present invention, and a person of ordinary skill in the art may still derive other drawings from these accompanying drawings without creative efforts.

FIG. 1 is a schematic structural diagram of a thermoelectric cool which does not form part of the present invention, but which is helpful to understand the present invention;

FIG. 2 is a schematic diagram of an optical sub-assembly having the thermoelectric cooler in FIG. 1;

FIG. 3 is a schematic structural diagram of a thermoelectric cooler according to an embodiment of the present invention;

FIG. 4 is a schematic structural diagram of a thermoelectric cooler which does not form part of the present invention, but which is helpful to understand the present invention;

FIG. 5 is a schematic diagram of an optical sub-assembly having the thermoelectric cooler according to an embodiment of the invention; and

FIG. 6 is a schematic structural diagram of a thermoelectric cooler according to an embodiment of the present invention.

### DESCRIPTION OF EMBODIMENTS

To make the invention objectives, features, and advantages of the present invention clearer and more comprehensible, the following clearly describes the technical solutions in the embodiments of the present invention with reference to the accompanying drawings in the embodiments of the present invention. The present invention is defined by the appended independent claim.

In the specification, claims, and accompanying drawings of the present invention, the terms "first", "second", "third", "fourth", and so on (if existent) are intended to distinguish between similar objects but do not necessarily indicate a specific order or sequence. It should be understood that the data termed in such a way are interchangeable in proper circumstances so that the embodiments of the present invention described herein can be implemented in orders except the order illustrated or described herein. Moreover, the terms "include", "contain" and any other variants mean to cover the non-exclusive inclusion, for example, a process, method, system, product, or device that includes a list of steps or units is not necessarily limited to those units, but may include other units not expressly listed or inherent to such a process, method, system, product, or device.

The following provides detailed descriptions separately by using specific embodiments.

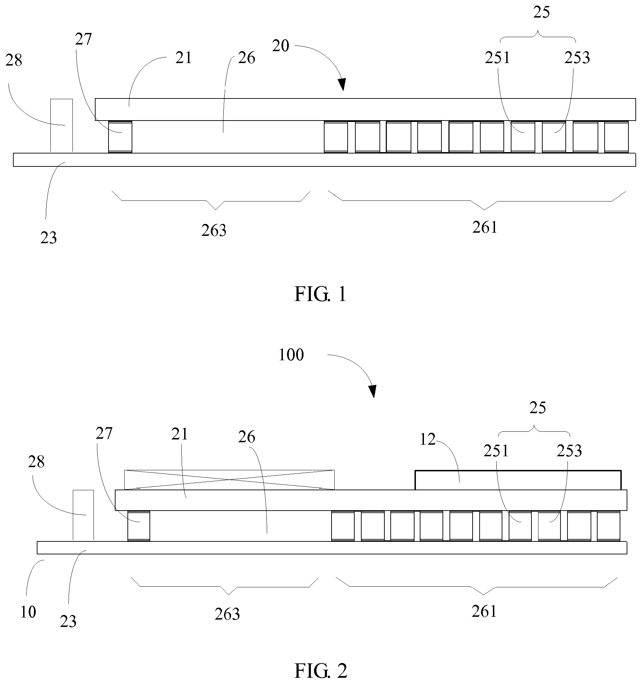

Referring to FIG. 1 and FIG. 2, a first embodiment not forming part of the present invention, but helpful to understand the present invention provides a thermoelectric cooler 20 and an optical sub-assembly 100 having the thermoelectric cooler 20. The optical sub-assembly 100 includes a base 10 and a heat source device 12. The thermoelectric cooler 20 includes a first base plate 21, a second base plate 23, and multiple couples of first elements 25. The first base plate 21 is configured to support the heat source device 12. An accommodation space 26 is formed between the first base plate 21 and the second base plate 23. The multiple couples of first elements 25 are arranged at intervals within the accommodation space 26, and the multiple couples of first elements 25 are all connected to the first base plate 21 and the second base plate 23. The multiple couples of first elements 25 are connected to an external power source to adjust their cooling or heating effect by receiving a voltage or a current and implement temperature control on the heat source device 12. The accommodation space 26 includes a first area 261 and a second area 263 adjacent to the first area 261. The first area 261 is disposed in a correspondence to the heat source device 12, and density of first elements 25 in the first area 261 is greater than density of first elements 25 in the second area 263. The thermoelectric cooler is installed on the base 10, and is configured to support the heat source device 12 of the optical sub-assembly 100 and perform temperature control on the heat source device 12. The second base plate 23 contacts a surface of the base 10.

Further, the multiple couples of first elements 25 are all arranged in the first area 261. The second area 263 is a vacant area; or a support body connected between the first base plate 21 and the second base plate 23 is disposed in the second area 263.

In a first implementation of this embodiment, preferably, a support body 27 connected between the first base plate 21 and the second base plate 23 is disposed in the second area 263. There is one or more support bodies 27, and a size of the support body 27 is the same as a size of the element. In another implementation, the second area 23 is a vacant area. A support body 27 is disposed in the second area 263, and the support body 27 is made of a non-thermoelectric material. The support body 27 is configured to support the first base plate 21. When there are multiple support bodies 27, they may be arranged regularly in the second area 263.

Still, in a second implementation of this embodiment, the thermoelectric cooler further includes one or more couples of second elements (not marked in the figure). The one or more couples of second elements are arranged in the second area 263. When there are multiple couples of second elements, an arrangement manner in the second area 263 is different from a gradual decrease arrangement manner, for example, the second elements are arranged in a matrix form. In addition, density of second elements in the second area 263 is less than the density of the first elements 25 in the first area 261. The second elements are connected to the external power source.

Specifically, the base 10 is a flat plate, and is configured to support the thermoelectric cooler 20. The thermoelectric cooler 20 is installed on a surface 11 of the base 10. The second base plate 23 contacts the surface 11. Both the first base plate 21 and the second base plate 23 are rectangular plates. The first base plate 21 is disposed in parallel with the second base plate 23. The first base plate 21 is configured to support the heat source device 12 and other electronic components, for example, a laser chip. In this embodiment, the heat source device 12 is a laser chip. The heat source device 12 is disposed on a surface of the first base plate 21 far away from the second base plate 23, and is located above the first area 261. In addition, the heat source device 12 is located at one end of the first base plate 21. In this embodiment, division of the first area 261 and the second area 263 may be determined according to the position occupied by the heat source device 12, so long as it is ensured that the heat source device 12 is located above the first area 261 and disposed opposite to the first area 261.

The multiple couples of first elements 25 are located in the first area 21. Two opposite ends of each first element are respectively connected to the first base plate 21 and the second base plate 23. A direction from left to right within the accommodation space 26 is used as a horizontal direction, and a direction vertical to the horizontal direction is used as a vertical direction. In the horizontal direction, the multiple couples of first elements 25 are in one column, or in multiple columns disposed at intervals. In the vertical direction, the multiple couples of first elements 25 are in one column, or in multiple columns disposed at intervals. In this embodiment, five couples of first elements 25 are disposed compactly at intervals in the horizontal direction.

Further, each couple of first elements 25 includes two element bodies. The two element bodies are an element body 251 and an element body 253 respectively. The element body 251 and the element body 253 are arranged at an interval and are both connected to the first base plate 21 and the second base plate 23, that is, two opposite ends of the element body 251 and the element body 253 are respectively connected to the first base plate 21 and the second base plate 23. In this embodiment, the element body 251 and the element body 253 are arranged and disposed in parallel. In another implementation, the element body 252 and the element body 253 may be arranged in disorder. The element body 251 and the element body 253 include different dopants, so that the element body 251 and the element body 253 have an opposite performance relationship, for example, an electron-hole relationship. In this embodiment, the element body 251 is a P-type element that includes electrons and is formed by a BiTe-type material with a dopant. The element body 253 is an N-type element that includes holes and is formed by a BiTe-type material with a dopant. Therefore, when a current enters the element body 251 from a bottom of the element body 251, and then enters the element body 253 from a top, the element body 251 and the element body 253 transfer heat in a same direction.

Further, the first base plate 21 and the second base plate 23 are made of an aluminum nitride material, an aluminum oxide material, or a silicon carbide material. In this embodiment, the first base plate 21 is made of an aluminum nitride material, and the second base plate 23 is made of an aluminum oxide material.

Further, the thermoelectric cooler 20 further includes a conductor 28 that is located on the second base plate 23 and is close to the accommodation space 26. The conductor 28 is electrically connected to one of two element bodies in outermost first elements within the accommodation space 26, and all element bodies in the multiple couples of first elements 25 are connected in series. Specifically, the conductor 28 is connected to the external power source to supply power to the first elements. The conductor 28 is disposed at one end of the second base plate 23. A conductive metal sheet is disposed between the conductor 28 and the second base plate 23, and configured to electrically connect to the first elements. Specifically, in a first couple of first elements 25 that is within the accommodation space and close to the conductor 28, a first metal sheet is disposed between the element body 251 and the second base plate 23. The conductor and the element body 251 are connected in series by using the first metal sheet. The element body 251 and the element body 253 are connected in series by using a second metal sheet disposed on the first base plate 21. The element body 251 in a second group and the element body 253 in the first group are connected in series by using a third metal sheet disposed on the second base plate 23, and so on. In this way, all elements in the multiple couples of first elements 25 are electrically connected in series. A current transmitted by the conductor 28 to the first element body 25 moves from the second base plate 23 toward the first base plate 21 through the first element body 25, enters the element body 253 through the first metal sheet, and flows back to the second base plate 23. The current makes a waveform motion track. In this process, using cooling of the heat source device 12 as an example, all electrons in the element body 251 and holes in the second element body move from the first base plate 21 to the second base plate 23, and at the same time, transfer heat from the first base plate 21 to the second base plate 23. Finally, heat transfer from the first base plate 21 to the second base plate is implemented, heat on the first base plate 21 is reduced, and temperature stability of the heat source device 12 is improved.

Further, the thermoelectric cooler further includes a temperature detector (not shown in the figure) and a control circuit. The temperature detector is connected to the heat source device 12 to detect a temperature of the heat source device 12 and transfer the temperature to the control circuit. The control circuit is configured to control voltage values or current values on the multiple couples of first elements 25, so that the heat source device 12 keeps a temperature balance, that is, an objective of temperature control in a temperature range is achieved. In this embodiment, the temperature detector is a thermistor.

Further, the thermoelectric cooler further includes a passive optical component disposed on the first base plate 21. The passive optical component is located on one side opposite to the second area 263. The passive optical component is an optical component or the like that does not emit heat itself, but requires an ambient temperature range. When the passive optical component is disposed, a quantity of first elements or second elements in the second area 263 is increased to improve an ambient temperature condition of the passive optical component.

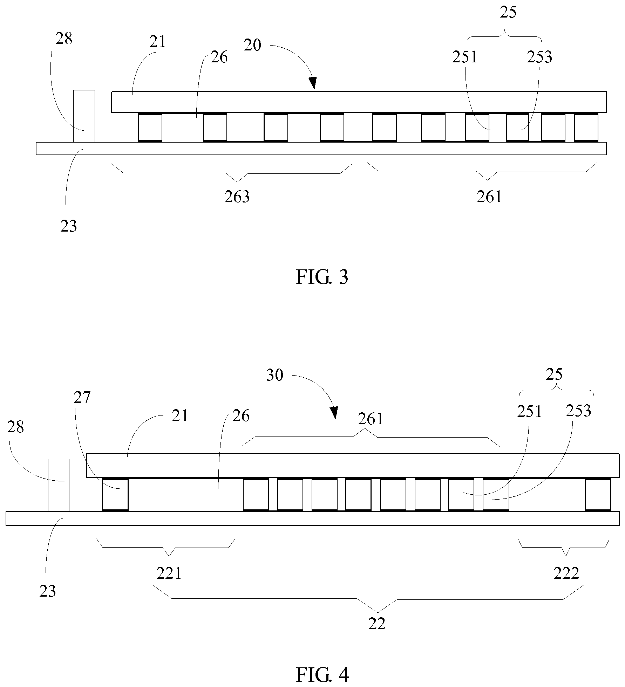

Referring to FIG. 3, in a second embodiment, forming part of the present invention, a difference from the first embodiment lies in an element arrangement manner. That is, the multiple couples of first elements 25 are arranged in a first area 261 and a second area 263, and the multiple couples of first elements 25 are arranged in such a manner that density gradually decreases in a direction from the first area 261 to the second area 263. In this embodiment, density of elements in the first area 261 is greater, and heat of the heat source device 12 disposed on the first base plate 21 can be better conducted, so that the temperature of the heat source device 12 is within a specified range. In this embodiment, division of the first area 261 and the second area 263 is determined according to an area occupied by the heat source device 12. In addition, a boundary between the first area 261 and the second area 263 may be located between two element bodies in one couple of first elements, or may be located between two couples of elements.

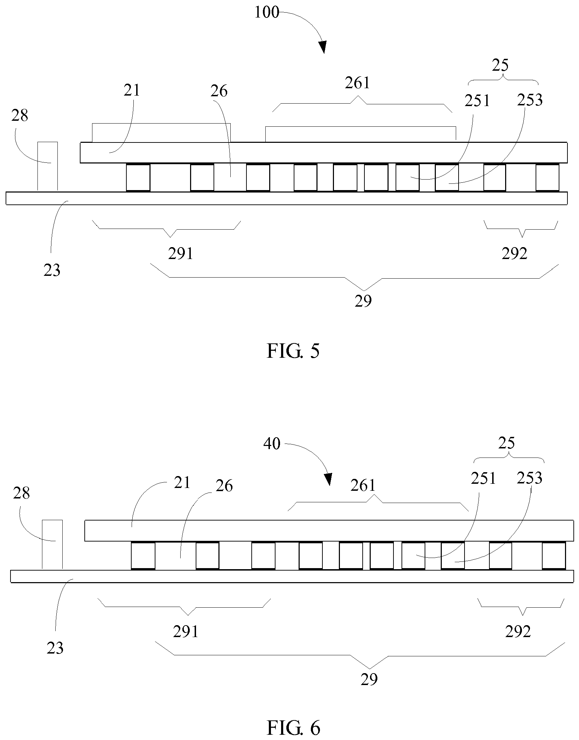

Referring to FIG. 4 and FIG. 5, in a third embodiment of which the implementation shown in Figure 4 does not form part of the present invention but is merely helpful to understand the present invention, whilst the implementation shown in Figure 5 forms part of the present invention, the multiple couples of elements in the thermoelectric cooler 30 are disposed in the first area 261. The second area 22 includes a first subarea 221 and a second subarea 222. The first subarea 221 and the second subarea 222 are respectively located on two sides of the first area 261, and the first subarea 221 and the second subarea 222 are vacant areas; or a support body 27 connected between the first base plate 21 and the second base plate 23 is disposed in at least one subarea in the first subarea 221 and the second subarea 222. Preferably, the first subarea 221 and the second subarea 222 are vacant areas.

Further, in an implementation of the third embodiment which does not form part of the present invention, a support body 27 is disposed in both the first subarea 221 and the second subarea 222. The support body 27 is made of a non-thermoelectric material, and is mainly configured to support the first base plate 21. In another implementation, a support body 27 configured to support the first base plate 21 is disposed in the first subarea 221 or the second subarea 222. In this manner, support bodies 27 may be arranged regularly. It should be noted that, when the support body 27 is made of a non-thermoelectric material, multiple couples of first elements 25 in the first area 261 are all located in the first area 261 in pairs; or the support body 27 is located between two couples of elements, and multiple support bodies 27 are alternately disposed with the multiple couples of elements.

Further, in another implementation of the third embodiment forming part of the present invention, the thermoelectric cooler further includes one or more couples of second elements (not marked in the figure). The second elements are disposed in at least one subarea in the first subarea 221 and the second subarea 222. The second elements are connected to an external power source. When there are multiple couples of second elements, an arrangement manner in the first subarea 221 or the second subarea 222 is different from a gradual decrease arrangement manner. It should be noted that, when there are second elements, one element in one couple of first elements 25 in adjacent positions of the first area 261 and the second area 22 may be located in the first area 261, and the other one is located in the second area 22, or both are located in the first area. Density of second elements in the second area 22 is less than density of first elements 25 in the first area 261, showing a gradual decrease.

In this manner, heat dissipation may be performed in a larger area on the first base plate 21, so that the temperature of the heat source device 12 is within a specified range.

Further, the heat source device 12 is located in a position different from ends of the first base plate 21. For example, the heat source device 12 is located in a middle of the first base plate 21 or in a position near a middle. In this embodiment, the heat source device 12 is located in a middle position on the first base plate 21 (as shown in FIG. 5).

Referring to FIG. 6, in a fourth embodiment of the present invention, the multiple couples of first elements 25 in the thermoelectric cooler 40 are arranged in the first area 261 and the second area 29. The second area 29 includes a first subarea 291 and a second subarea 292. The first subarea 291 and the second subarea 292 are respectively located on two sides of the first area 261. The multiple couples of first elements 25 are arranged in such a manner that density gradually decreases in a direction from the first area 261 to the first subarea 291 and in a direction from the first area 261 to the second subarea 292. Density of elements in the first area 261 is greater, and a part of heat of the heat source device 12 disposed on the first base plate 21 can be better dissipated, so that the temperature of the heat source device 12 is within a specified range.

In the present invention, density of element bodies in a position corresponding to the heat source device 12 is gradually increased, so that the thermoelectric cooler 20 dissipates heat of the heat source device 12 on the first base plate in time. In addition, in view of a problem of uneven heat distribution of a heat source in the prior art, element bodies are arranged properly in the present invention. This can effectively dissipate heat in a heat source centralization position, enhance a cooling effect of the TEC, and further increase a coefficient of performance (COP) value of the TEC. It is understandable that, the thermoelectric cooler 20 in the present invention may also be applicable to an electronic component, for example, a CPU, in addition to an optical sub-assembly.

The present invention further provides an optical module. The optical module includes a housing (not shown in the figure) and the optical sub-assembly 100 having the thermoelectric cooler 20 in any one of the foregoing embodiments. The optical sub-assembly 100 is disposed in the housing.

What are disclosed above are merely examples of embodiments of the present invention, and certainly are not intended to limit the protection scope of the present invention which is solely defined by the appended independent claim.

## Claims

1. A thermoelectric cooler (20), configured to support a heat source device (12) and perform temperature control on the heat source device (12), wherein the thermoelectric cooler (20) comprises a first base plate (21), a second base plate (23) disposed opposite to the first base plate (21), and multiple couples of first elements (25), the first base plate (21) is configured to support the heat source device (12), an accommodation space (26) is formed between the first base plate (21) and the second base plate (23), the multiple couples of first elements (25) are arranged at intervals within the accommodation space (26), the multiple couples of first elements (25) are all connected to the first base plate (21) and the second base plate (23), the multiple couples of first elements (25) are connected to an external power source to adjust a temperature difference between the first base plate (21) and the second base plate (23) by changing a voltage or a current and implement temperature control on the heat source device (12), the accommodation space (26) comprises a first area (261) and a second area (263) adjacent to the first area (261), the first area (261) is disposed in a correspondence to the heat source device (12), and density of first elements (25) in the first area (261) is greater than density of first elements (25) in the second area (263);
wherein the first area (261) is connected to the second area (263), the multiple couples of first elements (25) are arranged in the first area (261) and the second area (263), and the multiple couples of first elements (25) are arranged in such a manner that density gradually decreases in a direction from the first area (261) to the second area (263);
wherein each couple of first elements (25) comprises two element bodies, and the two element bodies are disposed at an interval and are both connected to the first base plate (21) and the second base plate (23); and
wherein the thermoelectric cooler (20) further comprises a conductor (28) that is disposed on the second base plate (23) and is close to the accommodation space (26), the conductor (28) is electrically connected to one of two element bodies in an outermost couple of first elements within the accommodation space (26), and all element bodies in the multiple couples of first elements (25) are connected in series.

2. The thermoelectric cooler (20) according to claim 1, wherein the second area (263, 29) comprises a first subarea (291) and a second subarea (292), the first subarea (291) and the second subarea (292) are respectively located on two sides of the first area (261), and the multiple couples of first elements (25) are arranged in such a manner that density gradually decreases in a direction from the first area (261) to the first subarea (221) and in a direction from the first area (261) to the second subarea (222).

3. The thermoelectric cooler (20) according to any one of claims 1 to 2, wherein the thermoelectric cooler (20) further comprises a temperature detector and a control circuit, the temperature detector is connected to the heat source device to detect a temperature of the heat source device (12) and transfer the temperature to the control circuit, and the control circuit is configured to control voltage values or current values on the multiple couples of first elements (25).

4. The thermoelectric cooler (20) according to any one of claims 1 to 2, wherein the first base plate (21) and the second base plate (23) are made of an aluminum nitride material, an aluminum oxide material, or a silicon carbide material.

5. The thermoelectric cooler (20) according to any one of claims 1 to 2, wherein the thermoelectric cooler (20) further comprises a passive optical component disposed on the first base plate (21), and the passive optical component is located on one side opposite to the second area (263).

6. An optical sub-assembly (100), comprising a base, wherein the optical sub-assembly (100) further comprises the thermoelectric cooler (20) according to any one of claims 1 to 5, the thermoelectric cooler (20) is installed on the base, and the second base plate (23) contacts a surface of the base.

7. An optical module, comprising a housing, wherein the optical module further comprises the optical sub-assembly (100) according to claim 6, and the optical sub-assembly (100) is disposed in the housing.

## Patentansprüche

1. Thermoelektrischer Kühler (20), der dazu konfiguriert ist, eine Wärmequellenvorrichtung (12) zu tragen und eine Temperaturregelung an der Wärmequellenvorrichtung (12) durchzuführen, wobei der thermoelektrische Kühler (20) eine erste Basisplatte (21), eine zweite Basisplatte (23), die gegenüber der ersten Basisplatte (21) angeordnet ist, und mehrere Paare von ersten Elementen (25) umfasst, die erste Basisplatte (21) dazu konfiguriert ist, die Wärmequellenvorrichtung (12) zu tragen, ein Aufnahmeraum (26) zwischen der ersten Basisplatte (21) und der zweiten Basisplatte (23) ausgebildet ist, die mehreren Paare von ersten Elementen (25) in Abständen innerhalb des Aufnahmeraums (26) angeordnet sind, sämtliche der mehreren Paare von ersten Elementen (25) mit der ersten Basisplatte (21) und der zweiten Basisplatte (23) verbunden sind, die mehreren Paare von ersten Elementen (25) mit einer externen Leistungsquelle verbunden sind, um eine Temperaturdifferenz zwischen der ersten Basisplatte (21) und der zweiten Basisplatte (23) durch Ändern einer Spannung oder eines Stroms einzustellen und eine Temperaturregelung an der Wärmequellenvorrichtung (12) umzusetzen, der Aufnahmeraum (26) einen ersten Bereich (261) und einen zweiten Bereich (263) umfasst, der benachbart zu dem ersten Bereich (261) ist, der erste Bereich (261) in einer Entsprechung zu der Wärmequellenvorrichtung (12) angeordnet ist und eine Dichte von ersten Elementen (25) in dem ersten Bereich (261) größer als eine Dichte von ersten Elementen (25) in dem zweiten Bereich (263) ist;
wobei der erste Bereich (261) mit dem zweiten Bereich (263) verbunden ist, die mehreren Paare von ersten Elementen (25) in dem ersten Bereich (261) und dem zweiten Bereich (263) angeordnet sind und die mehreren Paare von ersten Elementen (25) so angeordnet sind, dass die Dichte in einer Richtung von dem ersten Bereich (261) zu dem zweiten Bereich (263) allmählich abnimmt;
wobei jedes Paar von ersten Elementen (25) zwei Elementkörper umfasst und die zwei Elementkörper in einem Abstand angeordnet sind und beide mit der ersten Basisplatte (21) und der zweiten Basisplatte (23) verbunden sind; und
wobei der thermoelektrische Kühler (20) ferner einen Leiter (28) umfasst, der auf der zweiten Basisplatte (23) angeordnet ist und in der Nähe des Aufnahmeraums (26) ist, wobei der Leiter (28) elektrisch mit einem von zwei Elementkörpern in einem äußersten Paar von ersten Elementen innerhalb des Aufnahmeraums (26) verbunden ist und sämtliche Elementkörper in den mehreren Paaren von ersten Elementen (25) in Reihe geschaltet sind.

2. Thermoelektrischer Kühler (20) nach Anspruch 1, wobei der zweite Bereich (263, 29) einen ersten Teilbereich (291) und einen zweiten Teilbereich (292) umfasst, sich der erste Teilbereich (291) und der zweite Teilbereich (292) jeweils auf zwei Seiten des ersten Bereichs (261) befinden und die mehreren Paare von ersten Elementen (25) so angeordnet sind, dass die Dichte in einer Richtung von dem ersten Bereich (261) zu dem ersten Teilbereich (221) und in einer Richtung von dem ersten Bereich (261) zu dem zweiten Teilbereich (222) allmählich abnimmt.

3. Thermoelektrischer Kühler (20) nach einem der Ansprüche 1 bis 2, wobei der thermoelektrische Kühler (20) ferner einen Temperaturdetektor und eine Steuerschaltung umfasst, wobei der Temperaturdetektor mit der Wärmequellenvorrichtung verbunden ist, um eine Temperatur der Wärmequellenvorrichtung (12) zu erfassen und die Temperatur an die Steuerschaltung zu übertragen, und die Steuerschaltung dazu konfiguriert ist, Spannungswerte oder Stromwerte an den mehreren Paaren von ersten Elementen (25) zu steuern.

4. Thermoelektrischer Kühler (20) nach einem der Ansprüche 1 bis 2, wobei die erste Basisplatte (21) und die zweite Basisplatte (23) aus einem Aluminiumnitridmaterial, einem Aluminiumoxidmaterial oder einem Siliziumkarbidmaterial hergestellt sind.

5. Thermoelektrischer Kühler (20) nach einem der Ansprüche 1 bis 2, wobei der thermoelektrische Kühler (20) ferner eine passive optische Komponente umfasst, die auf der ersten Basisplatte (21) angeordnet ist, und sich die passive optische Komponente auf einer Seite befindet, die dem zweiten Bereich (263) gegenüberliegt.

6. Optische Unterbaugruppe (100), umfassend eine Basis, wobei die optische Unterbaugruppe (100) ferner den thermoelektrischen Kühler (20) nach einem der Ansprüche 1 bis 5 umfasst, wobei der thermoelektrische Kühler (20) auf der Basis installiert ist und die zweite Basisplatte (23) eine Fläche der Basis berührt.

7. Optisches Modul, umfassend ein Gehäuse, wobei das optische Modul ferner die optische Unterbaugruppe (100) nach Anspruch 6 umfasst und die optische Unterbaugruppe (100) in dem Gehäuse angeordnet ist.

## Revendications

1. Refroidisseur thermoélectrique (20), configuré pour supporter un dispositif source de chaleur (12) et effectuer un contrôle de température sur le dispositif source de chaleur (12), dans lequel le refroidisseur thermoélectrique (20) comprend une première plaque de base (21), une seconde plaque de base (23) disposée à l'opposé de la première plaque de base (21), et de multiples couples de premiers éléments (25), la première plaque de base (21) est configurée pour supporter le dispositif source de chaleur (12), un espace de logement (26) est formé entre la première plaque de base (21) et la seconde plaque de base (23), les multiples couples de premiers éléments (25) sont disposés à intervalles dans l'espace de logement (26), les multiples couples de premiers éléments (25) sont tous connectés à la première plaque de base (21) et à la seconde plaque de base (23), les multiples couples de premiers éléments (25) sont connectés à une source d'alimentation externe pour ajuster une différence de température entre la première plaque de base (21) et la seconde plaque de base (23) en modifiant une tension ou un courant et mettre en œuvre une commande de température sur le dispositif source de chaleur (12), l'espace de logement (26) comprend une première zone (261) et une seconde zone (263) adjacente à la première zone (261), la première zone (261) est disposée en correspondance avec le dispositif source de chaleur (12), et la densité des premiers éléments (25) dans la première zone (261) est supérieure à la densité des premiers éléments (25) dans la seconde zone (263) ;
dans lequel la première zone (261) est reliée à la seconde zone (263), les multiples couples de premiers éléments (25) sont disposés dans la première zone (261) et la seconde zone (263), et les multiples couples de premiers éléments (25) sont disposés de telle manière que la densité diminue progressivement dans une direction allant de la première zone (261) à la seconde zone (263) ;
dans lequel chaque couple de premiers éléments (25) comprend deux corps d'éléments, et les deux corps d'éléments sont disposés à un intervalle et sont tous deux reliés à la première plaque de base (21) et à la seconde plaque de base (23) ; et
dans lequel le refroidisseur thermoélectrique (20) comprend en outre un conducteur (28) qui est disposé sur la seconde plaque de base (23) et qui est proche de l'espace de logement (26), le conducteur (28) est connecté électriquement à l'un des deux corps d'élément dans un couple de premiers éléments le plus à l'extérieur à l'intérieur de l'espace de logement (26), et tous les corps d'éléments dans les multiples couples de premiers éléments (25) sont connectés en série.

2. Refroidisseur thermoélectrique (20) selon la revendication 1, dans lequel la seconde zone (263, 29) comprend une première sous-zone (291) et une seconde sous-zone (292), la première sous-zone (291) et la seconde sous-zone (292) sont respectivement situées sur deux côtés de la première zone (261), et les multiples couples de premiers éléments (25) sont disposés de telle manière que la densité diminue progressivement dans une direction allant de la première zone (261) à la première sous-zone (221) et dans une direction allant de la première zone (261) à la seconde sous-zone (222).

3. Refroidisseur thermoélectrique (20) selon l'une quelconque des revendications 1 à 2, dans lequel le refroidisseur thermoélectrique (20) comprend en outre un détecteur de température et un circuit de commande, le détecteur de température est connecté au dispositif source de chaleur pour détecter une température du dispositif source de chaleur (12) et transférer la température au circuit de commande, et le circuit de commande est configuré pour commander des valeurs de tension ou des valeurs de courant sur les multiples couples de premiers éléments (25).

4. Refroidisseur thermoélectrique (20) selon l'une quelconque des revendications 1 à 2, dans lequel la première plaque de base (21) et la seconde plaque de base (23) sont constituées d'un matériau en nitrure d'aluminium, d'un matériau en oxyde d'aluminium ou d'un matériau en carbure de silicium.

5. Refroidisseur thermoélectrique (20) selon l'une quelconque des revendications 1 à 2, dans lequel le refroidisseur thermoélectrique (20) comprend en outre un composant optique passif disposé sur la première plaque de base (21), et le composant optique passif est situé sur un côté opposé à la seconde zone (263).

6. Sous-ensemble optique (100), comprenant une base, dans lequel le sous-ensemble optique (100) comprend en outre le refroidisseur thermoélectrique (20) selon l'une quelconque des revendications 1 à 5, le refroidisseur thermoélectrique (20) est installé sur la base, et la seconde plaque de base (23) entre en contact avec une surface de la base.

7. Module optique, comprenant un boîtier, dans lequel le module optique comprend en outre le sous-ensemble optique (100) selon la revendication 6, et le sous-ensemble optique (100) est disposé dans le boîtier.
